# EUROPEAN PATENT APPLICATION

(11) **EP 4 593 237 A1**
(43) Date of publication of application: **30.07.2025**
(21) Application number: 24747208.7
(22) Date of filing: 18.01.2024
(51) Int. Cl.: H02J 7/00, H01M 10/04, H01M 10/48

(54) **CHARGE/DISCHARGE TESTING DEVICE**

(30) Priority: 27.01.2023 JP 2023011423
(71) Applicant: Kataoka Corporation, Kyoto-shi, Kyoto 601-8203 (JP)
(72) Inventor: ONISHI, Katsuaki, Kyoto-shi, Kyoto 601-8203 (JP); SEGAWA, Fujio, Kyoto-shi, Kyoto 601-8203 (JP); FUKUDA, Mikio, Kyoto-shi, Kyoto 601-8203 (JP); KAMO, Shigeo, Kyoto-shi, Kyoto 601-8203 (JP)
(74) Representative: Seemann & Partner Patentanwälte mbB
(86) International application number: PCT/JP2024/001360
(87) International publication number: WO 2024/157880

(57) **Abstract**

A charge/discharge testing device 1 performs charge/discharge testing of secondary batteries and is characterized by including: a plurality of probes 16 that are positioned, with respect to a battery tray 7 in which a plurality of secondary batteries 8 are mounted, on the positive electrode side of the plurality of secondary batteries 8, and that correspond respectively to the plurality of secondary batteries; and a pressing unit 5 that includes a cooling means 14, is positioned on the side opposite the probes 16 across the battery tray 7, and moves in a vertical direction, thereby pressing the plurality of secondary batteries 8 toward the probes.

## Description

### TECHNICAL FIELD

The present invention relates to a charge and discharge testing device for performing a performance test on a secondary battery, and particularly to a technique for reducing a rise in temperature of a secondary battery to be tested.

### BACKGROUND ART

In recent years, secondary batteries that can be recharged and used repeatedly, such as lithium ion batteries, are used in a variety of electrical and electronic devices, hybrid vehicles, electric vehicles, and the like. In a final stage of the manufacturing process, such secondary batteries are subjected to a performance test in a charge and discharge testing device that repeatedly charges and discharges the batteries.

The performance test results of the secondary batteries are easily affected by temperature. Therefore, in the charge and discharge testing device, efforts are made to reduce a rise in the temperature of the secondary battery and to reduce temperature unevenness among a plurality of secondary batteries.

For example, Patent Literature 1 discloses a technique for reducing the temperature unevenness in batteries by providing an intake port on an upper side and a ventilation hole and an exhaust port on a lower side of the charge and discharge testing device, and by providing a plurality of fans capable of blowing temperature controlled air that flows in through a diffusion plate from above toward the batteries. Patent Literature 2 discloses a technique for reducing temperature interference from a power source to a battery by arranging a plurality of charging and discharging units, each of which integrates a power source and a probe, on one side (upper side) of the battery and providing a fan in a gap between the charging and discharging units.

### CITATION LIST

### PATENT LITERATURE

Patent Literature 1: Japanese Patent No. 7015026
Patent Literature 2: Japanese Patent No. 6470804

### SUMMARY OF INVENTION

### TECHNICAL PROBLEM

As described above, various efforts have been made to reduce a rise in the temperature of a secondary battery in the charge and discharge testing devices in the related art. However, the technique disclosed in Patent Literature 1 has a structure in which a charge and discharge testing device is simply combined with a thermostatic chamber, and this has the problem of making the device large. Further, the technique of Patent Literature 2 can reduce the temperature interference from the power source to the battery, but does not have the effect of reducing a rise in the temperature of the battery itself that accompanies the charge and discharge test.

The present invention has been made in view of the above problems, and an object of the present invention is to provide a charge and discharge testing device capable of effectively reducing a rise in the temperature of a secondary battery without enlarging the charge and discharge testing device.

### SOLUTION TO PROBLEM

In order to solve the above problems, the present invention provides a charge and discharge testing device for performing a charge and discharge test on secondary batteries, the charge and discharge testing device including a plurality of probes located on a positive electrode side of the plurality of the secondary batteries with respect to a battery tray in which a plurality of secondary batteries are loaded, each of the plurality of probes corresponding to a respective one of the plurality of secondary batteries; and a pressing unit including a cooling part, located opposite to the probes across the battery tray, and configured to move in an upper-lower direction to press the plurality of secondary batteries toward the probes.

### ADVANTAGEOUS EFFECTS OF INVENTION

According to the above configuration, in the charge and discharge testing device according to the present invention, the pressing unit including the cooling part is moved up and down to reduce a distance between the cooling part and the secondary battery during the charge and discharge test, and a rise in the temperature of the secondary battery can be effectively reduced. Further, by providing the cooling part in the pressing unit, it is possible to reduce an increase in the size of the device and the associated increase in costs.

### BRIEF DESCRIPTION OF DRAWINGS

[FIG. 1] FIG. 1 is a perspective view showing an overall configuration of a charge and discharge testing device 1 according to Embodiment 1.
[FIG. 2] FIG. 2 is a perspective view showing the charge and discharge testing device 1 during a charge and discharge test.
[FIG. 3] FIG. 3 is a cross-sectional view showing the charge and discharge testing device 1 during the charge and discharge test.
[FIG. 4] FIG. 4 is a diagram illustrating a cooling method (flow of cooling air) in the charge and discharge testing device 1.
[FIG. 5] (a), (b), and (c) of FIG. 5 are diagrams illustrating a probe of the charge and discharge testing device 1.
[FIG. 6] (a), (b), and (c) of FIG. 6 are diagrams illustrating a probe according to a reference technique.
[FIG. 7] FIG. 7 is a perspective view showing an overall configuration of a charge and discharge testing device 20 according to Embodiment 2.
[FIG. 8] FIG. 8 is a perspective view showing the charge and discharge testing device 20 during a charge and discharge test.

### DESCRIPTION OF EMBODIMENTS

### <Overview>

A charge and discharge testing device according to one aspect of the present embodiment performs a charge and discharge test on a secondary battery. The charge and discharge testing device includes: a plurality of probes located on a positive electrode side of the plurality of the secondary batteries with respect to a battery tray in which a plurality of secondary batteries are loaded, each of the plurality of probes corresponding to a respective one of the plurality of secondary batteries; and a pressing unit including a cooling part, located opposite to the probes across the battery tray, and configured to move in an upper-lower direction to press the plurality of secondary batteries toward the probes.

The pressing unit including the cooling part is moved up and down to reduce a distance between the cooling part and the secondary battery during the charge and discharge test, and a rise in the temperature of the secondary battery can be effectively reduced.

In the charge and discharge testing device according to another aspect of the present embodiment, each of the plurality of probes include a positive electrode probe and a negative electrode probe, and the charge and discharge testing device is a one-sided probe type that is configured to perform a charge and discharge test on the secondary batteries by bring the positive electrode probe and the negative electrode probe into contact with one end side of each of the secondary batteries.

According to the one-sided probe type, the wiring and the maintenance can be easily performed and therefore the cost can be reduced compared to the both-sided probe type in which a charge and discharge test is performed by bringing the probe into contact with terminals on both end sides of the secondary battery.

In the charge and discharge testing device according to another aspect of the present embodiment, the charge and discharge testing device includes the pressing unit on an upper side of the battery tray and a probe unit on a lower side of the battery tray, the plurality of probes being fixed to the probe unit, the charge and discharge testing device further includes a battery tray stand on which the battery tray is placed, and the pressing unit is configured to be lowered from above the battery tray stand such that the secondary batteries come into contact with the probes, and is configured to press the secondary batteries.

In this manner, the charge and discharge testing device can be applied to a bottom probe type. In a case of the bottom probe type, the charge and discharge testing device further includes an elevating cylinder configured to move the pressing unit and the battery tray stand up and down, in which the elevating cylinder is configured to lower the pressing unit and the battery tray stand together to bring each of the plurality of probes and the respective one of the plurality of secondary batteries into contact with each other, and then lower the pressing unit to bring the pressing unit into contact with and press an upper end portion of each of the secondary batteries.

Accordingly, the contact between the secondary battery and the probe can be reliably performed.

In the charge and discharge testing device according to another aspect of the present embodiment, the charge and discharge testing device includes a probe unit on an upper side of the battery tray and the pressing unit on a lower side of the battery tray, the plurality of probes being fixed to the probe unit, and the pressing unit is configured to be raised from below the battery tray stand until the secondary batteries come into contact with the probes, and is configured to press the secondary batteries.

According to this configuration, the probes are fixed and do not move up and down, so that the stability of contact with the secondary batteries is improved.

In the charge and discharge testing device according to another aspect of the present embodiment, the pressing unit includes a plurality of battery pressing parts configured to individually press each of the plurality of secondary batteries loaded in the battery tray toward a corresponding probe of the plurality of probes.

This makes it possible to press each secondary battery individually, and even if the battery tray is deformed due to bending or the like, the stability of contact with the probes is improved for all secondary batteries.

In the charge and discharge testing device according to another aspect of the present embodiment, the positive electrode probe is implemented by one coaxial probe, and the negative electrode probe is implemented by two monopole probes.

As described above, since the probes are arranged symmetrically with respect to the secondary batteries and are provided in the minimum number, the probes can be stably brought into contact with the secondary batteries in a well-balanced manner and the cooling efficiency of the cooling air is improved.

The charge and discharge testing device according to another aspect of the present embodiment further includes a product type switching part configured to selectively switch a stop position of the pressing unit configured to move in the upper-lower direction, according to a type of the secondary batteries.

Currently, a typical secondary battery in general use is the lithium ion battery, and there are several types of lithium ion batteries with different capacities and sizes. Therefore, by providing the charge and discharge testing device with a product type switching part, it becomes possible to carry out a charge and discharge test on a plurality of types of secondary batteries using a single device.

### <Embodiment 1>

Here, a charge and discharge testing device 1 according to an embodiment of the present invention will be described with reference to the drawings.

### (1) Overall Configuration of Charge and Discharge Testing Device 1

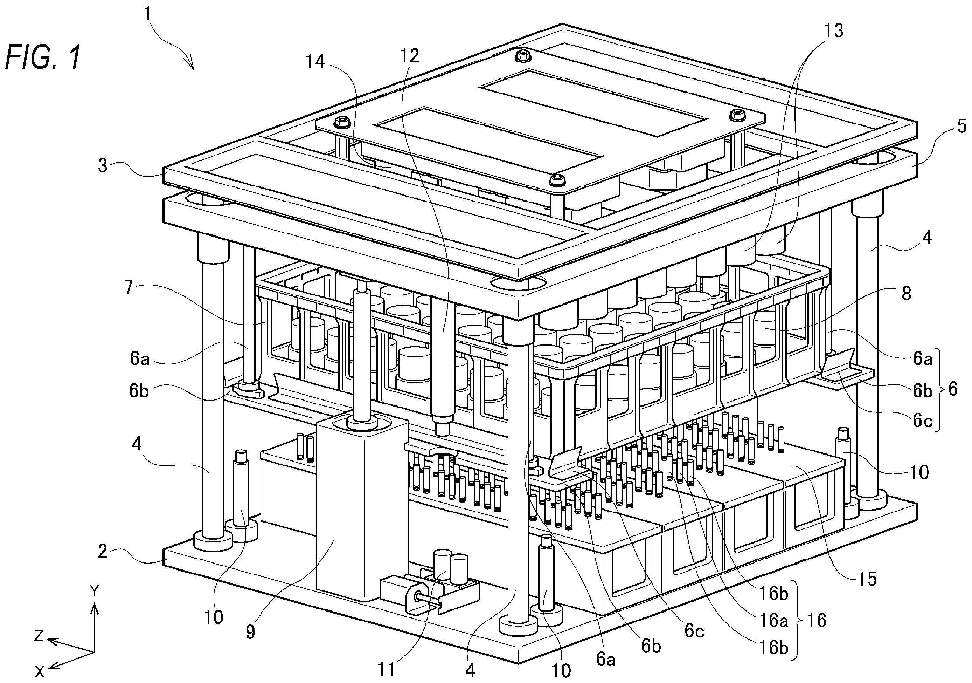

FIG. 1 is a perspective view showing an overall configuration of the charge and discharge testing device 1.

The charge and discharge testing device 1 is configured to perform a charge and discharge test involving charging and/or discharging of a plurality of secondary batteries 8 that are carried in a state of being accommodated in a battery tray 7, by connecting a probe 16 to each electrode of the secondary batteries 8.

The charge and discharge testing device 1 according to Embodiment 1 is of a one-sided probe type in which three probes 16 are brought into contact with one end side of each secondary battery 8 to perform the test. In particular, the charge and discharge testing device 1 according to Embodiment 1 is of a bottom probe type in which the probes 16 are positioned below the secondary batteries 8.

In the charge and discharge testing device 1, a lower frame 2 and an upper frame 3 are coupled by four support columns 4, and a probe unit 15 including a plurality of probes 16 is fixed to the lower frame 2. Each probe 16 is made of metal, and the probe unit 15 is made of an insulating material such as vinyl chloride. A base end portion of each probe 16 is supported by the probe unit 15. A pressing unit 5 for pushing the secondary batteries 8 toward the probes 16 is disposed between the frame 2 and the upper frame 3.

A battery tray stand 6 is suspended from the pressing unit 5. Specifically, the battery tray stand 6 includes four suspension rods 6a, two long bottom frames 6b suspended from the pressing unit 5 by the four suspension rods 6a, and a stopper 6c for horizontal positioning. When performing the charge and discharge test on the secondary batteries 8, a plurality of secondary batteries 8 to be tested are accommodated in the battery tray 7, and the battery tray 7 is then carried into the battery tray stand 6 of the charge and discharge testing device 1. In the charge and discharge testing device 1, the secondary batteries 8 are accommodated in the battery tray 7 with a positive electrode side facing downward and a negative electrode side facing upward. In this manner, the battery tray 7 in which a plurality of secondary batteries 8 loaded is placed on the bottom frames 6b of the battery tray stand 6.

The charge and discharge testing device 1 is provided with actuators 9 on the left and right, each of which includes an air cylinder or a hydraulic cylinder. The pressing unit 5 can be moved up and down in height by the actuators 9. Since the battery tray stand 6 is suspended from the pressing unit 5, the battery tray stand 6 also moves up and down integrally with the pressing unit 5.

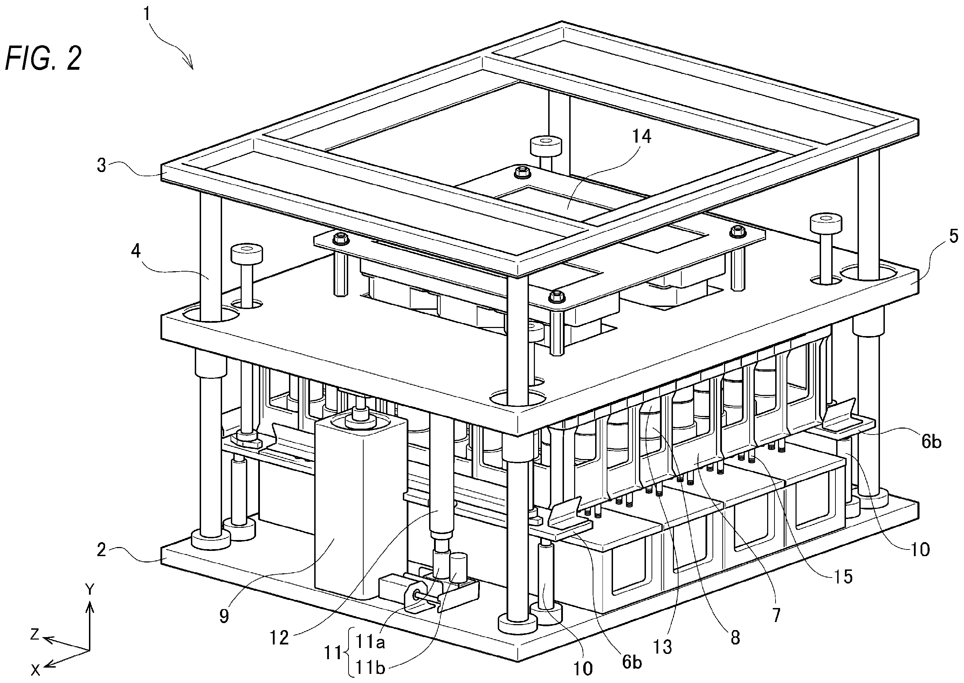

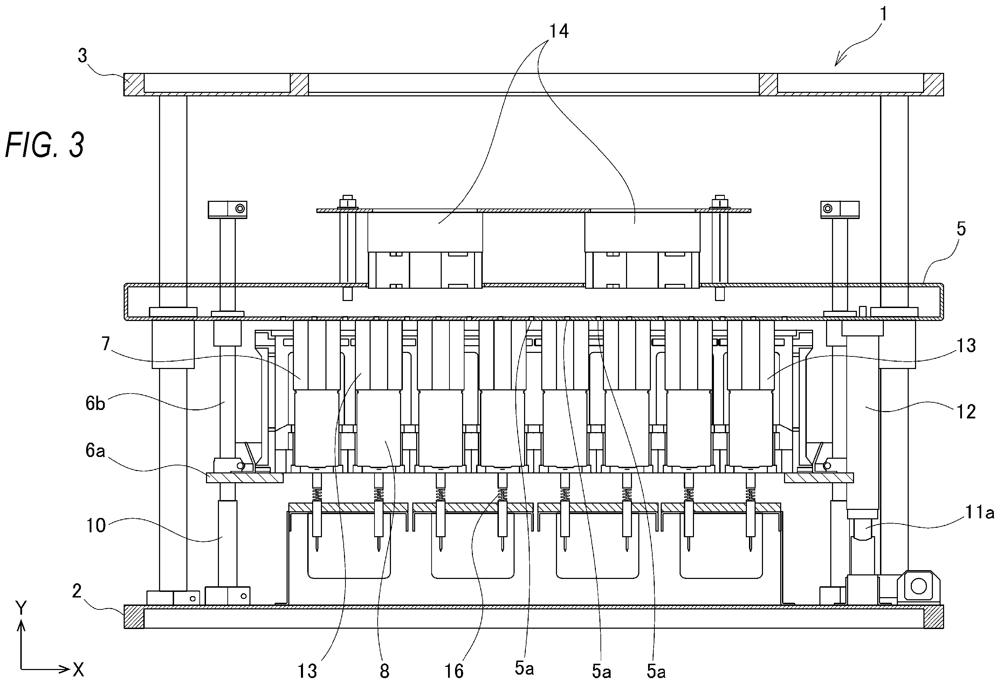

The charge and discharge testing device 1 in FIG. 1 is shown in an open state where the pressing unit 5 is located at an uppermost position, which is a state before and after the charge and discharge test. In the open state, the battery tray 7 is carried in and carried out using a stacker crane or the like. The charge and discharge testing device 1 in FIGS. 2 and 3 is shown in a closed state in which the pressing unit 5 is lowered for the charge and discharge test.

The pressing unit 5 is provided with battery pressing parts 13 in a number equal to the number of secondary batteries 8 that can be loaded into the battery tray 7. As an example, the battery pressing part 13 has a cylindrical shape, and a diameter of a bottom surface of the battery pressing part is substantially the same as a diameter of the secondary battery 8. The bottom surface of each battery pressing part 13 presses an upper surface of the corresponding secondary battery 8. Four stopper members 10 each having a built-in spring are fixed to the lower frame 2. As shown in FIGS. 2 and 3, the bottom frames 6b of the lowered battery tray stand 6 come into contact with upper surfaces of the stopper members 10, thereby restricting the height position of the battery tray 7.

First, in the charge and discharge testing device 1, in a case where the pressing unit 5 and the battery tray stand 6 are integrally lowered, the bottom frames 6b of the battery tray stand 6 come into contact with the upper surfaces of the stopper members 10, and the lowering of the battery tray stand 6 is stopped. At this time, the secondary batteries 8 are in a temporary contact state where the secondary batteries 8 are pushed up against the battery tray 7 by spring pressure of the probes 16. Subsequently, in a case where only the pressing unit 5 is lowered, each of the battery pressing parts 13 is brought into contact with the corresponding secondary battery 8, and while in this state, the pressing unit 5 is lowered to a position where a stopper member 12 comes into contact with a protruding portion (described later) of a product type switching part 11, so that a tip end of the probe 16, which is in temporary contact with the secondary battery 8, is pushed back downward. This allows the secondary batteries 8 and the probes 16 to be reliably brought into contact with each other.

In general, since the battery tray 7 is a resin molded product, the shape thereof may be deformed due to bending, distortion, or the like depending on the number of times of use, the frequency of use, or the like. In the case of a structure in which the height of the secondary battery 8 is determined by the bottom surface of the battery tray 7, if the battery tray 7 is used in a deformed state, a degree of contact between the probes 16 and the secondary batteries 8 may become uneven, which may result in a decrease in the accuracy of the charge and discharge test. For this reason, the charge and discharge testing device 1 is provided with the plurality of battery pressing parts 13 in the pressing unit 5, each of which corresponds to one of the secondary batteries 8. Since each battery pressing part 13 presses an individual secondary battery 8, appropriate pressure is applied to all of the secondary batteries 8 without having to consider deformation of the battery tray 7, and stable contact with the probes 16 can be achieved.

The secondary battery 8 targeted by the charge and discharge testing device 1 is, for example, a cylindrical lithium ion battery, but the cell sizes of a lithium ion battery currently in general use are 18650 size (18 mm in diameter × 65 mm in height) and 2170 size (21 mm × 70 mm). Further, there is also the 4680 size (46 mm × 80 mm), which is expected to become the standard specification for future electric vehicles. As the cell size increases, the deflection of the battery tray 7 also increases. Therefore, especially in the charge and discharge test of secondary batteries with large cell sizes, a configuration including battery pressing part 13 capable of pressing each secondary battery 8 is advantageous.

In order to correspond to a plurality of types of secondary batteries, the charge and discharge testing device 1 is provided with, on the left and right sides of the lower frame 2, the product type switching parts 11 for changing a lowering distance of the battery pressing parts 13 according to the size of the secondary battery 8 to be tested.

As shown in FIGS. 1 to 3, as an example, the product type switching part 11 includes two protruding portions 11a and 11b having different heights, and selectively uses one of the protruding portions 11a and 11b according to the type of the secondary battery 8 to be tested. Specifically, the product type switching part 11 includes any slide mechanism for displacing the positions of the protruding portion 11a and the protruding portion 11b on the upper surface of the lower frame 2. Further, the stopper member 12 is fixed to the pressing unit 5 at a position facing the product type switching part 11, the protruding portion 11a or the protruding portion 11b is selected for use according to the type of the secondary battery 8 to be tested, and the position of the selected protruding portion 11a or 11b is displaced by the slide mechanism so that the selected protruding portion 11a or 11b comes into contact with the stopper member 12. As a result, the downward movement of the battery pressing parts 13 are stopped due to the contact between the protruding portion 11a or the protruding portion 11b and the stopper member 12.

### (2) Cooling Method of Charge and Discharge Testing Device 1

As shown in FIG. 1, a top plate of the pressing unit 5 is provided with two cooling parts 14. The cooling parts 14 have a function of reducing a rise in the temperature of the secondary batteries 8 during a charge and discharge test so that the temperature does not rise by, for example, 10°C or more above the surrounding environment temperature. As an example, the cooling parts of the present embodiment include a radiator (heat exchanger) and a fan, and generate cooling air to be supplied to each secondary battery 8. If the secondary batteries generate large amounts of heat due to charging and discharging, a measurement value is affected. In particular, large secondary batteries tend to generate large amounts of heat due to charging and discharging. When a variation occurs in the cell temperature due to the effect of self-heating, an erroneous determination may be caused in which a non-defective product is recognized as a defective product.

As an example, the cooling parts 14 of the charge and discharge testing device 1 supply water at a temperature lower than the surrounding environment temperature by about 5°C, and further supply air (cooling air) cooled by outside air to the battery tray 7.

As described above, in the charge and discharge testing device 1, the pressing unit 5 moves downward for the charge and discharge test, and accordingly, the cooling parts 14 fixed to the pressing unit 5 also move downward. Accordingly, the cooling parts 14 can cool the secondary batteries 8 from a very close vicinity of the secondary batteries 8 during the charge and discharge test. Compared to a case where a cooling part is fixed to the device, the cooling effect can be improved.

FIG. 3 is a cross-sectional view of the charge and discharge testing device 1. As shown in the drawing, the pressing unit 5 has a hollow structure, and has a function of accumulating air (cooling air) cooled by the cooling parts 14 in the inside (hollow structure) to make the temperature uniform. Further, the pressing unit 5 has a plurality of slits 5a, and the uniform cooling air is supplied to the secondary batteries 8 via the slits 5a.

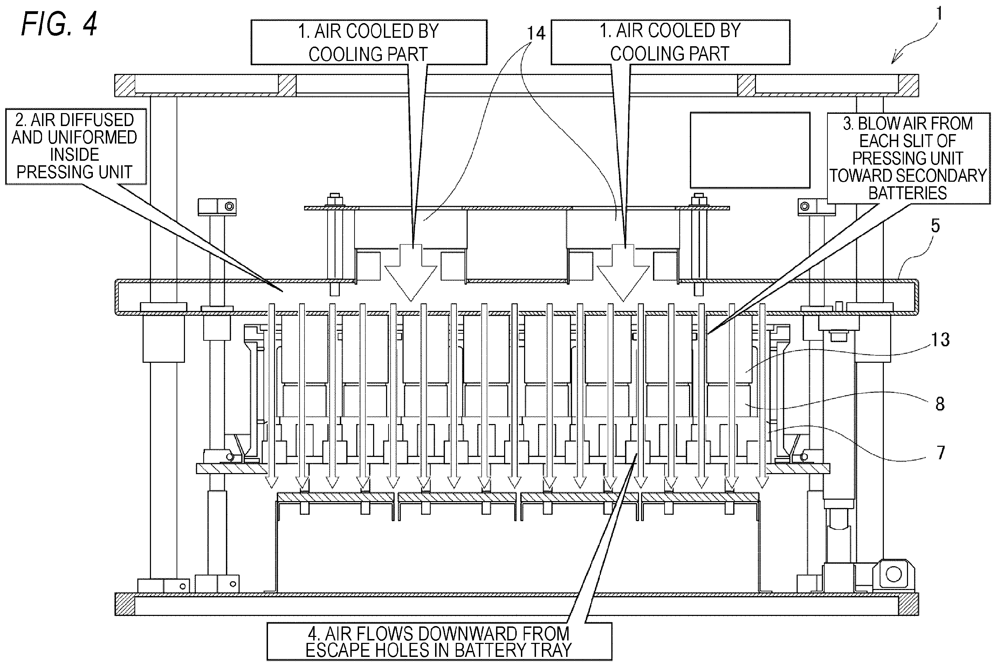

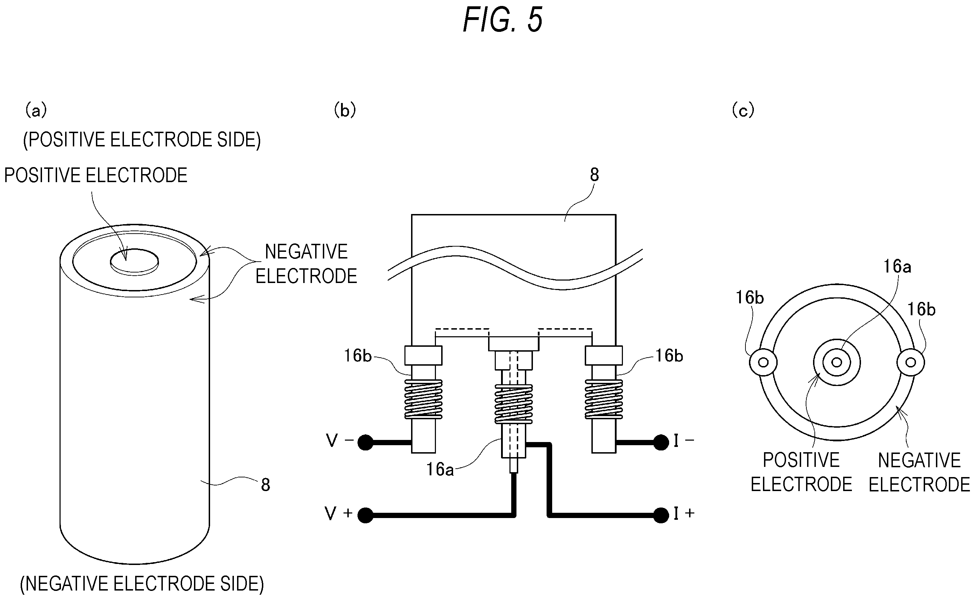

A cooling method of the charge and discharge testing device 1 will be further described with reference to FIGS. 4 and 5. As shown in FIG. 4, the cooling air cooled by the two cooling parts 14 enters and diffuses inside the pressing unit 5, and the temperature is made uniform. This is to uniformly cool the plurality of secondary batteries 8 regardless of the installation position of the cooling parts 14. Subsequently, the cooling air is blown from each slit 5a of the pressing unit 5 toward the secondary batteries 8. The battery tray 7 is formed with sufficient escape holes (ventilation holes) so that the cooling air generated by the cooling parts 14 can pass through the secondary batteries 8 and be exhausted to the outside. The cooling air passes around the secondary batteries 8 and is exhausted to the outside through the ventilation holes in the battery tray 7.

### (3) Configuration of Probe 16

The charge and discharge testing device 1 is configured to perform the charge and discharge test by bringing the tip end of the probe 16 into contact with one end of the secondary battery 8, and supplying a power supply voltage from a power source (not shown) to the probe 16 to charge the secondary battery 8, and/or discharging the charge stored in the secondary battery 8 through the probe 16. Further, the charge and discharge testing device 1 is configured to measure the magnitude of a current flowing through the probe 16 and a voltage between terminals of the secondary battery 8 during charging and discharging of the secondary battery 8.

The probe 16 used in the charge and discharge testing device 1 is of a one-sided probe type in which the tip end of the probe 16 is brought into contact with the one end of the secondary battery 8. There is also a both-sided probe type in which a charge and discharge test is performed by bringing the probe into contact with both ends of a secondary battery. However, compared with the both-sided probe type, the one-sided probe type is easier to wire and maintain, and therefore has cost advantages.

(a) of FIG. 5 is a perspective view showing a general appearance of the secondary battery 8 to be tested by the charge and discharge testing device 1. As shown in the figure, when focusing on an upper surface of the secondary battery 8, there is a positive electrode in the center and a negative electrode on an outer peripheral edge. In the charge and discharge testing device 1, each secondary battery 8 is accommodated in the battery tray 7 with the upper surface facing downward.

As shown in (b) of FIG. 5, the probe 16 used in the present embodiment includes one coaxial probe 16a (V+, I+) and two monopole probes 16b (V-, I-). The coaxial probe 16a is brought into contact with the positive electrode, and two monopole' probes 16b are brought into contact with the negative electrode. The coaxial probe 16a allows a current terminal and a voltage terminal to be connected to one probe. The configuration using one probe can save space and reduce costs compared to a configuration using a plurality of probes. In addition, since the number of probes is small, the cooling air can easily pass through and the cooling effect is also improved.

Here, as shown in (b) and (c) of FIG. 5, a contact surface shape of the probe 16a on the positive electrode side is the same as a contact surface shape of the probe 16b on the negative electrode side, the coaxial probe 16a on the positive electrode side has the entire contact surface in contact with the positive electrode of the secondary battery 8, and the monopole probe 16b on the negative electrode side has a part of the contact surface in contact with the negative electrode. This allows the probes 16 to reliably contact the individual secondary batteries 8 even if the batteries are misaligned. The two monopole probes 16b on the negative electrode side are arranged at positions facing each other with the coaxial probe 16a on the positive electrode side in between. This makes it possible to ensure good balance during contact.

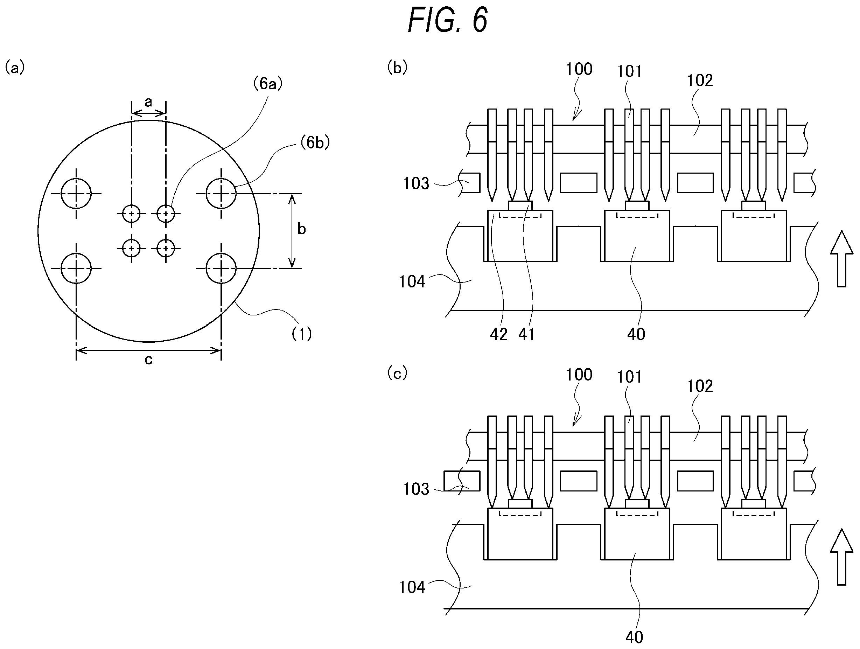

Next, probes according to reference technique 1 and reference technique 2 will be described with reference to FIG. 6. (a) of FIG. 6 is a diagram illustrating the probe according to reference technique 1. Reference technique 1 is an upper probe type charge and discharge testing device in which probes are positioned above a secondary battery (1), four probes (6a) for a positive electrode are in contact with the center of the secondary battery (1), and four probes (6b) for a negative electrode are in contact with the periphery.

(b) and (c) of FIG. 6 are diagrams illustrating the probe according to reference technique 2. A charge and discharge testing device according to reference technique 2 is also an upper probe type. In the test on the secondary battery, with respect to a secondary battery 40 placed on a battery tray 104, first, four contact probes 101 arranged on the inner side are brought into contact with a first electrode terminal 41 of the secondary battery ((b) of FIG. 6). Thereafter, four contact probes 101 arranged on the outer side are brought into contact with a second electrode terminal 42 of the secondary battery ((c) of FIG. 6).

In both reference technique 1 and reference technique 2, a total of eight probes, four probes for the positive electrode and four probes for the negative electrode, are brought into contact with the secondary battery for test. On the other hand, the charge and discharge testing device 1 according to the present embodiment is configured to perform the test by bringing a total of three probes, one for the positive electrode and two for the negative electrode, into contact with the secondary battery 8. Compared with these reference techniques, the number of probes is smaller and the effect of the cooling air from the cooling part 14 can be fully exerted.

### (4) Effects of Embodiments

As described above, according to the charge and discharge testing device 1, by operating the cooling part 14 in the vicinity of the secondary battery 8 during the charge and discharge test to cool the secondary battery 8, it is possible to reduce a rise in the temperature of the secondary battery 8 and to perform an accurate test. Therefore, by improving the accuracy of defect determination and ranking determination of the secondary batteries 8, it is possible to improve the yield of secondary batteries 8 and reduce costs.

Further, by providing the cooling part 14 in the pressing unit 5, it is possible to reduce an increase in the size of the device and the associated increase in costs.

### <Embodiment 2>

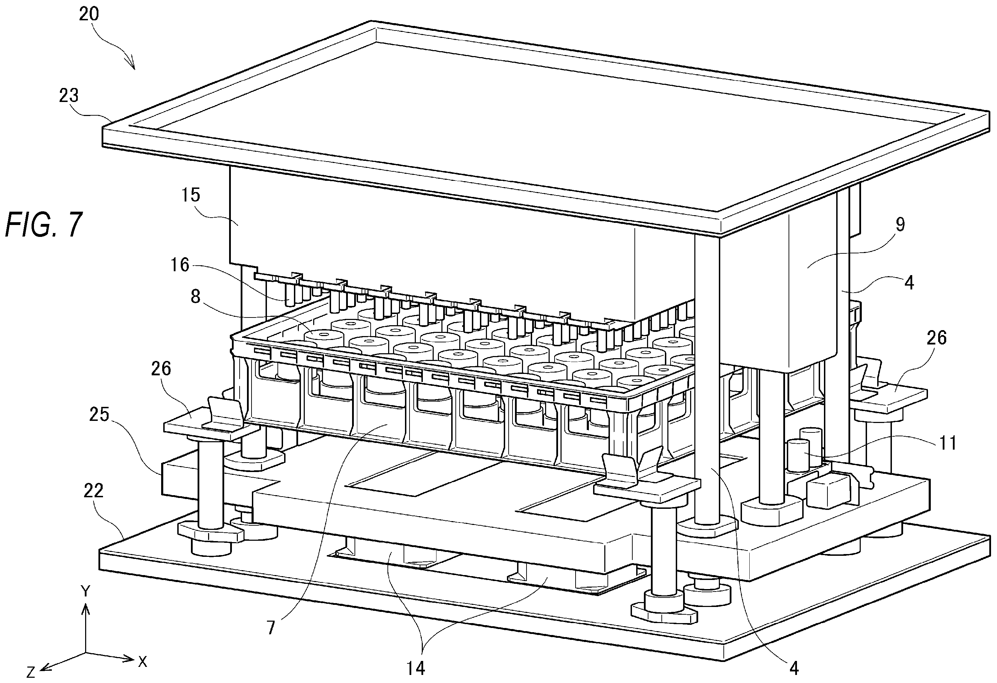

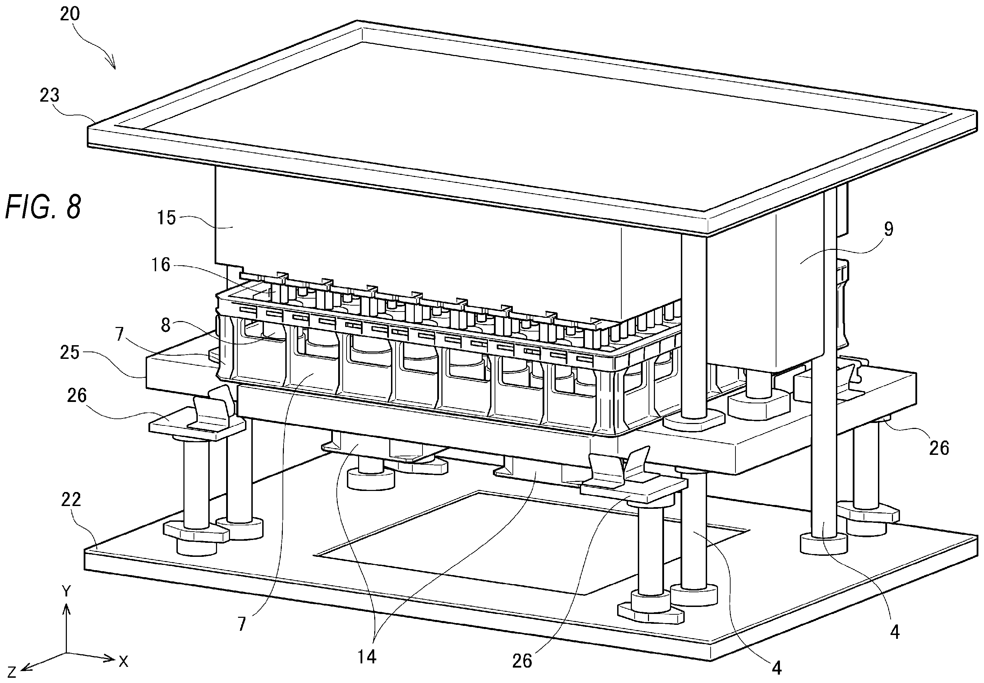

Here, Embodiment 2, which is one aspect of the present invention, will be described. Similarly to the charge and discharge testing device 1 according to Embodiment 1, a charge and discharge testing device 20 according to Embodiment 2 is of a one-sided probe type in which three probes 16 are brought into contact with one end side of each secondary battery 8 to perform the test. The difference with the charge and discharge testing device 1 is that the charge and discharge testing device 20 is of an upper probe type in which the probes 16 are located above the secondary batteries 8. Therefore, the components described in Embodiment 1 are arranged substantially upside down. In the charge and discharge testing device 20, the secondary batteries 8 are accommodated in a battery accommodating portion of the battery tray 7 with the positive electrode side facing upward and the negative electrode side facing downward. In FIGS. 7 and 8, components having the same structures and/or the same functions as those of Embodiment 1 are denoted by the same reference numerals as those of Embodiment 1.

As shown in FIGS. 7 and 8, in the charge and discharge testing device 20, a lower frame 22 and an upper frame 23 are coupled by four support columns 4. The probe unit 15 including a plurality of probes 16 is fixed to the upper frame 23, and a battery tray stand 26 is fixed to the lower frame 22. The battery tray 7 in which a plurality of secondary batteries 8 to be tested loaded is placed on the battery tray stand 26. The structure of the battery tray 7 is as described in Embodiment 1.

A pressing unit 25 for pushing the secondary batteries 8 toward the probes 16 is disposed between the lower frame 22 and the upper frame 23.

Similarly to the charge and discharge testing device 1, the charge and discharge testing device 20 is provided with the actuators 9 on the left and right, each of which includes an air cylinder or a hydraulic cylinder. The pressing unit 25 can be moved up and down in height by the actuators 9. When performing the charge and discharge test, as shown in FIG. 8, the pressing unit 25 is raised to push up the battery tray 7 with an upper surface of the pressing unit 25, and the battery tray 7 is pressed toward the probe unit 15. Thus, each secondary battery 8 is brought into contact with the corresponding probe 16. Note that the charge and discharge testing device 20 is also provided with the product type switching part 11 in the pressing unit 25 so as to handle a plurality of types of secondary batteries.

In a case where the battery tray 7 is in the open state (FIG. 7), the battery tray 7 is placed on the battery tray stand 26. In a case where the pressing unit 25 rises, once the pressing unit 25 comes into contact with the battery tray 7, the battery tray 7 is separated the battery tray stand 26 and is placed on the upper surface of the pressing unit 25 as shown in FIG. 8.

The pressing unit 25 includes two cooling parts 14. The pressing unit 25 moves upward for the charge and discharge test, and accordingly, the cooling parts 14 fixed to the pressing unit 25 also move upward. Accordingly, the cooling parts 14 can cool the secondary batteries 8 from a very close vicinity of the secondary batteries 8 during the charge and discharge test, and the cooling effect can be improved as compared with the case where the cooling part is fixed to the device.

As described above, according to the charge and discharge testing device 20, while the probe 16 and the secondary battery 8 are in reliable contact with each other, the cooling part 14 is operated in the vicinity of the secondary battery 8 during the charge and discharge test to cool the secondary battery 8, so that it is possible to reduce a rise in the temperature of the secondary battery 8 and to perform an accurate test. Therefore, by improving the accuracy of defect determination and ranking determination of the secondary batteries 8, it is possible to improve the yield of secondary batteries 8 and reduce costs.

In Embodiment 2, the probe unit 15 is fixed to the upper frame 23 and does not move up and down, so that the stability of the connection between each probe 16 and the secondary battery 8 is improved.

In addition, it is possible to achieve the charge and discharge testing device 20 capable of uniformly and efficiently cooling the battery with a small size and at low cost.

### <Other Modifications>

As described above, the charge and discharge testing device 1 and the charge and discharge testing device 20 have been described as embodiments of the present invention. However, the present invention is not limited to the charge and discharge testing device 1 and the charge and discharge testing device 20 described above, and the above-described Embodiment 1 and Embodiment 2 may be modified as follows.

Here, modifications of Embodiment 1 and Embodiment 2 will be described. Embodiment 1 and Embodiment 2 described above and the modifications to be described below can be combined in any manner.
(1) In Embodiment 1, the pressing unit 5 includes the battery pressing parts 13 in a number equal to the number of the probes 16, but this configuration is not essential. For example, a configuration may be in which one battery pressing part presses a plurality of secondary batteries 8, or a configuration may be in which the battery tray 7 accommodating a plurality of secondary batteries 8 is collectively pressed as described in Embodiment 2.
(2) In Embodiment 1 and Embodiment 2, two cooling parts 14 are mounted on the pressing unit 5 and the pressing unit 25, but this configuration is not essential. It is sufficient if there is only one cooling part 14. Further, when two or more cooling parts 14 are provided, the arrangement may be optional.
(3) In Embodiment 1 and Embodiment 2, the product type switching part 11 may be deleted, or the number of the protruding portion may be increased depending on the type of the secondary battery to be tested.
(4) In Embodiment 2, the pressing unit 25 may be provided with a battery pressing part that presses the individual secondary batteries 8.
(5) Embodiment 1 and Embodiment 2 have been described using an example of a cylindrical secondary battery, and a secondary battery having a rectangular shape may also be used.

### REFERENCE SIGNS LIST

1 charge and discharge testing device (Embodiment 1)
2 lower frame
3 upper frame
4 support column
5 pressing unit
6 battery tray stand
7 battery tray
8 secondary battery
9 actuator (elevating cylinder)
10 stopper member
11 product type switching part
12 stopper member
13 battery pressing part
14 cooling part
15 probe unit
16 probe
20 charge and discharge testing device (embodiment 2)
22 lower frame
23 upper frame
25 pressing unit
26 battery tray stand

## Claims

1. A charge and discharge testing device for performing a charge and discharge test on secondary batteries, the charge and discharge testing device comprising:
a plurality of probes located on a positive electrode side of the plurality of the secondary batteries with respect to a battery tray in which a plurality of secondary batteries are loaded, each of the plurality of probes corresponding to a respective one of the plurality of secondary batteries; and
a pressing unit including a cooling part, located opposite to the probes across the battery tray, and configured to move in an upper-lower direction to press the plurality of secondary batteries toward the probes.

2. The charge and discharge testing device according to claim 1,
wherein each of the plurality of probes include a positive electrode probe and a negative electrode probe, and
wherein the charge and discharge testing device is a one-sided probe type that is configured to perform a charge and discharge test on the secondary batteries by bring the positive electrode probe and the negative electrode probe into contact with one end side of each of the secondary batteries.

3. The charge and discharge testing device according to claim 2,
wherein the charge and discharge testing device includes the pressing unit on an upper side of the battery tray and a probe unit on a lower side of the battery tray, the plurality of probes being fixed to the probe unit,
wherein the charge and discharge testing device further includes a battery tray stand on which the battery tray is placed, and
wherein the pressing unit is configured to be lowered from above the battery tray stand such that the secondary batteries come into contact with the probes, and is configured to press the secondary batteries.

4. The charge and discharge testing device according to claim 3, further comprising:
an elevating cylinder configured to move the pressing unit and the battery tray stand up and down,
wherein the elevating cylinder is configured to:
lower the pressing unit and the battery tray stand together to bring each of the plurality of probes and the respective one of the plurality of secondary batteries into contact with each other; and
then lower the pressing unit to bring the pressing unit into contact with and press an upper end portion of each of the secondary batteries.

5. The charge and discharge testing device according to claim 2,
wherein the charge and discharge testing device includes a probe unit on an upper side of the battery tray and the pressing unit on a lower side of the battery tray, the plurality of probes being fixed to the probe unit, and
wherein the pressing unit is configured to be raised from below the battery tray stand until the secondary batteries come into contact with the probes, and is configured to press the secondary batteries.

6. The charge and discharge testing device according to claim 5,
wherein the pressing unit includes a plurality of battery pressing parts configured to individually press each of the plurality of secondary batteries loaded in the battery tray toward a corresponding probe of the plurality of probes.

7. The charge and discharge testing device according to claim 3,
wherein the pressing unit includes a plurality of battery pressing parts configured to individually press each of the plurality of secondary batteries loaded in the battery tray toward a corresponding probe of the plurality of probes.

8. The charge and discharge testing device according to claim 2,
wherein the positive electrode probe is implemented by one coaxial probe, and the negative electrode probe is implemented by two monopole probes.

9. The charge and discharge testing device according to claim 1, further comprising:
a product type switching part configured to selectively switch a stop position of the pressing unit configured to move in the upper-lower direction, according to a type of the secondary batteries.
